# EUROPEAN PATENT APPLICATION

(11) **EP 2 326 009 A1**
(43) Date of publication of application: **25.05.2011**
(21) Application number: 09176669.1
(22) Date of filing: 20.11.2009
(51) Int. Cl.: H03K 19/177

(54) **Reset/load and signal distribution network**

(71) Applicant: Panasonic Corporation, Kadoma-shi Osaka 571-0051 (JP)
(72) Inventor: Olgiati, Andrea, Temple Quay, Bristol BS1 6EA (GB)
(74) Representative: Haley, Stephen

(57) **Abstract**

A tree-like signal distribution network comprises a plurality of branches extending from a plurality of branching points. The distribution network comprises a plurality of control blocks, each control block being situated at a branching point of the tree-like distribution network, wherein each of the plurality of control blocks is arranged such that it can distribute a signal received from the tree-like distribution network, a locally generated signal, and a combination of a signal received from the tree-like distribution network and a locally generated signal.

## Description

The present invention relates to the field of reset signals in programmable logic devices. More specifically, the present invention relates to a new method of generating, distributing and using a reset/load signal in programmable logic devices such as Field Programmable Gate Arrays (FPGAs) or those implemented using the D-Fabrix Architecture (DFA), as described in US6353841, US6252792 and US2002/0157066.

"Reset" and "load" signals are widely used in Application-Specific Integrated Circuits (ASICs). A "reset" signal is used for putting a component of the ASIC (or the entire ASIC) into a known state. A "load" signal is typically used to allow or stop the advancement of the state of the ASIC. These reset and load signals are generally distributed in a programmable logic (PL) device by way of a dedicated reset or load distribution network.

Programmable logic (PL) devices, such as the DFA or FPGAs, have dedicated reset signal distribution networks which are connected to each user-visible register in the device. Accordingly, each reset signal distributed using the network will reset the entire PL device. A disadvantage of this is that, when only a part of the PL device needs to be reset, a locally-generated reset signal must be distributed using the data distribution network of the PL device, thereby using up valuable routing resources.

There are certain cases in which a "reset" line can be used inside an application which has been mapped onto a PL device. For example, it may be required to reset a counter to zero. In such situations however, because of the need to drive the reset line from outside the device, using the dedicated "reset" line is complicated and costly. In order to remedy this problem, a part of the PL can be configured to generate the appropriate "reset" signal. As will be appreciated however, this uses up valuable space on the PL.

Thus, because the reset network and the data network are separated, it is not possible to combine the two. For example, if it is required that all the registers on the PL device be reset when a first condition OR a second condition is reached, where the first condition is an external condition (e.g. a specific voltage being sent to a specific pin of the device) and the second condition is an internal condition (e.g. a specific error state being reached), it is not possible to combine these two conditions internally using know PL devices. Accordingly, the resetting of a specific element, for example a large number of registers, will need to be done using either external means or, more costly internal means.

Accordingly, there is a clear need for an improved reset and signal distribution network which will not suffer from the abovementioned disadvantages.

In order to solve the problems associated with the prior art, the present invention provides a tree-like signal distribution network having a plurality of branches which extend downstream from a plurality of branching points, the network comprises:
a plurality of control blocks, each control block being situated at a branching point of the tree-like distribution network and being arranged to distribute a signal received from the tree-like distribution network, a locally generated signal, and a combination of a signal received from the tree-like distribution network and a locally generated signal.

Preferably, each control block comprises:
a first control block input connected to the tree-like distribution network;
a second control block input for inputting the locally generated signal;
selecting means the for selecting the locally generated signal, the selecting means having a signal input connected to the first control block input, a signal output and a control signal input; and
combining means for combining the locally generated signal and the signal received from the tree-like distribution network, the combining means having a first input connected to the output of the selecting means, a second input connected to the first control clock input and an output connected to a plurality downstream branches of the tree-like distribution network.

Preferably, the selecting means comprises an AND gate; and the combining means comprises an OR gate.

Preferably, the output of combining means is connected to two downstream branches of the tree-like distribution network.

The present invention also provides a reconfigurable logic device comprises:
a tree-like distribution network, as described above;
an application data distribution network; and
a plurality of logic blocks, each logic block comprising at least one modified register, the modified register including:
   a register having an input connected to the application data distribution network and an input connected to the tree-like distribution network;
   an output connected to the application data distribution network; and
   switching means for switching either the input connected to the application data distribution network or the input connected to the tree-like distribution network to the output connected to the application data distribution network.

Preferably, the register comprises a DQ-type flip-flop and the switching means comprises a multiplexer.

The present invention also provide a method of propagating a signal in the above-described tree-like signal distribution network, the method comprises the steps of:
receiving a first signal from the tree-like signal distribution network;
receiving a second signal, the second signal being a locally generated signal;
selecting the first signal, the second signal or a combination of the first signal and the second signal as the propagation signal; and
propagating the propagation signal in the tree-like signal distribution network.

The present invention also provides a method of modifying a signal using the above-described tree-like signal distribution network, the method comprises the steps of:
receiving a first signal from the tree-like signal distribution network;
receiving a second signal from the tree-like signal distribution network; and
combining the first and second signals by inputting both signals into an OR gate.

The present invention also provides a method of using the above mentioned reconfigurable logic device, the method comprises the steps of:
receiving a first signal from the tree-like distribution network at the modified register; and
setting the switching means to output the first signal to the data distribution network.

As will be appreciated, the present invention provides several advantages over the prior art. For example, the present invention eliminates the need for the reset chain to leave the PL and return through the reset pin. Also, the present invention reduces the amount of logic needed in that it significantly reduces the amount dedicated to local reset signal generation circuits.

Specific embodiments of the present invention will now be described with reference to the accompanying drawings, in which:
Figure 1 shows a diagram representing a traditional implementation of reset and signal distribution network;
Figure 2 shows a diagram representing a detailed view of a logic block of Figure 1;
Figure 3 shows a diagram representing a register in accordance with the prior art;
Figure 4 shows a diagram representing an implementation of a reset and signal network in accordance with the present invention;
Figure 5 shows a diagram representing a detailed view of a logic block of Figure 4;
Figure 6 shows a more detailed view of the distribution control block of Figure 4;
Figure 7 shows a diagram representing a detailed functional view of a distribution control block in accordance with an embodiment of the present invention; and
Figure 8 shows a diagram representing a modified register in accordance with a second aspect of the present invention.

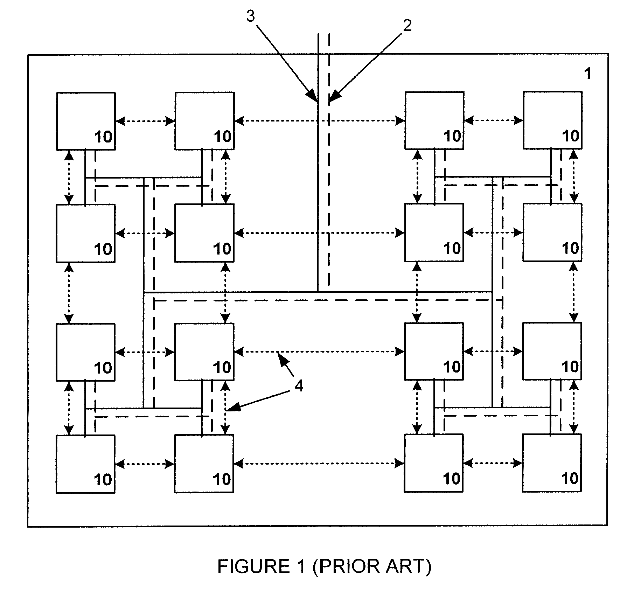

Figure 1 shows a diagram of a typical distribution network on a Programmable Logic (PL) device 1 for distributing a reset signal and data signals. As can be seen from Figure 1, each logic block 10 on the PL device 1 is potentially interconnected to its neighbouring logic block 10, thereby forming a data distribution network 4. This data distribution network 4 may be several bits wide and is programmable. The reset signal distribution network 3 however is a dedicated network which connects all logic blocks 10 in the PL 1 device to a single reset signal. Accordingly, because the single reset signal 2 will be sent to all logic blocks in the PL 1 device, each one of these will be reset. The reset signal distribution network 2 is generally an H-tree, though other configurations may be possible. For example, although the H-tree configuration of the present embodiment comprises two "branches" extending from each "branching point", the skilled reader will appreciate that the present invention could be used with a network having three or more branches for each "branching point".

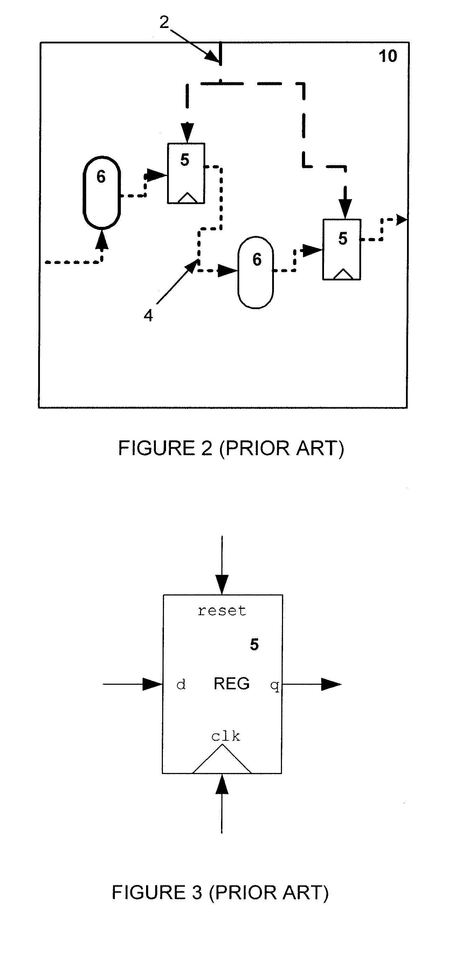

Figure 2 shows a diagram representing a detailed view of a logic block 10 of Figure 1. In this embodiment, the logic block 10 comprises two logic circuits 6 and two registers 5 for holding application data. As can be seen from Figure 2, the reset signal 2 is used to reset the registers 5 and the data distribution network 4 is used to push information into the logic circuits 6 and the registers 5.

Figure 3 shows a diagram representing a register in accordance with the prior art. The register 5 is a standard DQ flip-flop. Accordingly, at every positive clock edge, the value on the D input is captured by the register and presented to the output Q for one clock cycle, unless the reset pin is high - in which case the initialisation or "reset" value (typically 0) is captured by the register. The reset signal distribution network 3 is connected to the reset input of each register 5.

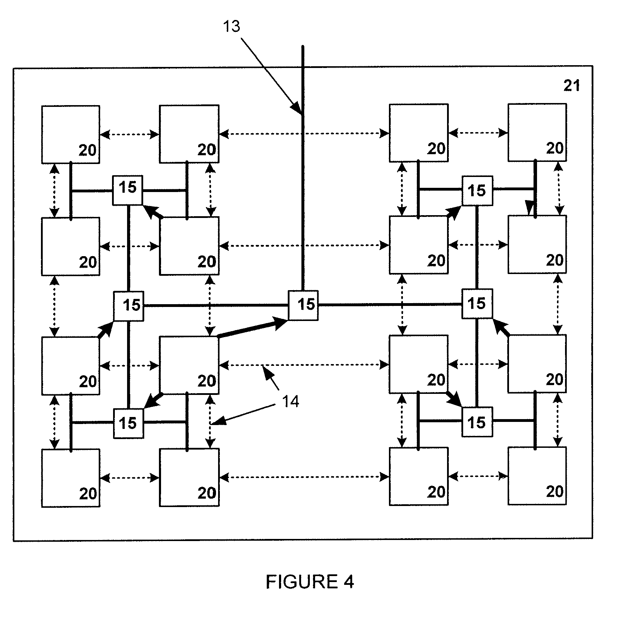

Figure 4 shows a diagram representing an implementation of a reset/load and signal distribution network in accordance with the present invention. The distribution network contained on the Programmable Logic PL device 21 comprises a plurality of logic blocks 20. Each logic block may be programmably connected to other logic blocks 20, thereby forming a data distribution network 14. This data distribution network 14 may be several bits wide. The reset signal distribution network 13 however is a dedicated network which connects all logic blocks 20 in the PL device 21. As can be seen from Figure 4, the reset and load distribution network 14 of this particular embodiment of the present invention has an H-tree configuration. That is to say that each branch of tree which forms the network terminates with at an intersection where two other branches commence.

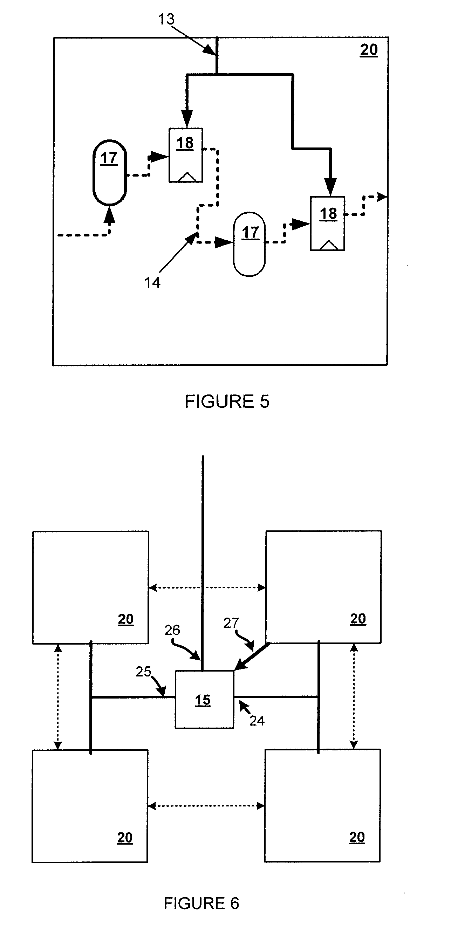

The PL device 21 in accordance with the present invention also comprises control blocks 15 situated at a select number of intersections of the H-tree network 13. Now, with reference to Figures 5 to 7, the structure and function of each control block will be described below.

Figure 5 shows a diagram representing a detailed view of a logic block 20 of Figure 4. In this embodiment, the logic block 10 comprises two logic circuits 17 for processing incoming application data and two registers 18 for holding application data (i.e. intermediate results of the computation effectuated by the logic circuits 17). As can be seen from Figure 5, the reset signal network 13 is used to reset the registers 18 and the data distribution network 14 is used to push information into the logic circuits 17 and the registers 18.

Figure 6 shows a more detailed view of the control block 15 of Figure 4. In particular, the control block 15 has an input 26 which is connected to the reset signal network 13, as well as a first output 24 and a second output 25 which are also both connected to the reset signal network 13. Finally, Figure 6 shows that the control block 15 has a control input 27, which can be programmably connected through the data distribution network 14 to at least one logic block 20 in PL device 21.

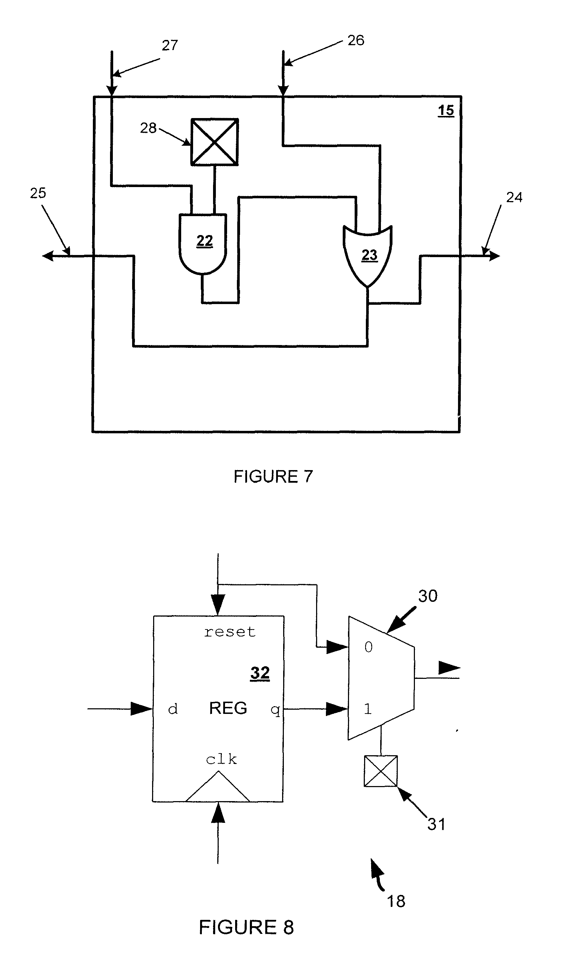

Figure 7 shows an internal functional view of a possible embodiment of control block 15 having an input 26 from the reset network, a control input 27, a first output 24 to the reset network and a second output 25 to the reset network. The first input 26 is connected to the first input of a two-input OR gate 23. The second input 27 is connected to the second input of a two-input AND gate 22. The first input of the two-input AND gate 22 is connected to a memory cell 28. The output of the AND gate is connected to the second input of the two-input OR gate 23. The output of the two-input OR gate 23 is connected to both the first output 24 and the second output 25. As will be appreciated, further outputs could also be connected to the output of the OR gate 23 in order to build other network configurations.

Now, with reference to Figure 4 and 7, the operation of the control block 15 in accordance with the present invention will now be described.

In a first state, the control block 15 will simply operate as a pass through, in which a reset signal arriving on input line 26 will be output on both output lines 24 and 25. As will be appreciated, in this mode, the reset network 13 of Figure 4, will simply function as a known reset network, thereby resetting all registers when a reset signal is propagated along reset network 13. The control block will operate in the first state when the memory cell 28 is set to logical LOW. In this state, the value of input 27 does not have any influence on the value of outputs 24 and 25.

In a second state, the control block 15 will propagate the signal received on the reset network input 16 and, in addition, the signal received on the control input 27. The control block will operate in the second state when the memory cell 28 is set to logical HIGH. Because each control block 15 shown in Figure 4 can receive a locally generated signal from an associated logic block 20, each control block 15 will be able to distribute rest signals locally. The logic function performed by control block 15 in this second state is "reset the target register if the chip-level reset 26 is high OR if the locally-generated reset 27 is high".

Although this embodiment refers to reset signals, it will be appreciated that the logic blocks 20 could indeed generate any type of useful signal and have it fan out over the reset/load distribution network. In this regard, a second aspect of the present invention could be used in conjunction with the abovementioned features.

This second aspect of the invention is shown in Figure 8, which depicts a diagram representing a modified register 18 in accordance with the present invention. The register 32 is a standard DQ flip-flop, in which, at every positive clock edge, the value on the D input is captured by the register and presented to the output Q, until the next positive clock edge. The reset distribution network 13 is connected the reset input of each register 32, as well as to the first input of the two-input multiplexer 30 of each modified register 18. The output of the register 32 is connected to the second input of the two-input multiplexer 30. The two-input multiplexer 30 is control by a value stored in a configuration memory cell 31.

In the example of Figure 8, when the configuration memory cell 31 is set to logical HIGH, the application mapped onto the PL device 21 will make use of the register 32 in a first mode. In this first mode of operation, the combination of register 32 and multiplexer 30 will perform in accordance with a register of the prior art, namely, at every positive clock edge, the value on the D input is captured by the register and presented to the output of multiplexer 30 for one clock cycle. Therefore, the register 32 will act to pass data along the data distribution network 14.

If however the configuration memory cell is set to a logical LOW, the contents of the reset distribution signal 12 will be fed through to the data distribution network 14. Accordingly, with the device of Figure 8, it is possible to pass signals along from the reset distribution network 13 to the data distribution network 14.

As will also be appreciated, in an embodiment of the invention where the control blocks 15 are used in conjunction with the modified registers 32, it will be possible for a first logic block 20 to generate a signal and send that signal, over the reset distribution network 13, to a plurality of other logic blocks 20, provided that the first logic block 20 is "upstream" from the plurality of other logic blocks 20 on the rest distribution network 13.

As will also be appreciated, the OR gate 23 of each control block 15 can modify a signal input into 26. A simple example of this is where the reset signal for the register 5 or 32 is defined by the data sequence "010101".

In this situation, if the memory cell 28 of a particular control block 15 was set to HIGH, and the signal 27 of the control block 15, input from a logic block 20, was equal to "111111 ", then the output of the OR gate 23 would be "111111", and so each logic block 20 downstream from that particular control block 15 would simply continuously receive a reset signal.

As will be appreciated, the above-described embodiment could be used to propagate any type of useful signal and is therefore not limited to the use of a reset signal.

## Claims

1. A tree-like signal distribution network (13) having a plurality of branches which extend downstream from a plurality of branching points, the network comprising:
a plurality of control blocks (15), each control block being situated at a branching point of the tree-like distribution network and being arranged to distribute a signal received from the tree-like distribution network, a locally generated signal, and a combination of a signal received from the tree-like distribution network and a locally generated signal.

2. The tree-like distribution network (13) of claim 1, wherein each control block (15) comprises:
a first control block input connected to the tree-like distribution network;
a second control block input for inputting the locally generated signal;
selecting means (22, 28) the for selecting the locally generated signal, the selecting means having a signal input connected to the first control block input, a signal output and a control signal input; and
combining means (23) for combining the locally generated signal and the signal received from the tree-like distribution network, the combining means having a first input connected to the output of the selecting means, a second input connected to the first control clock input and an output connected to a plurality downstream branches of the tree-like distribution network.

3. The tree-like signal distribution network (13) of any of the preceding claims, wherein:
the selecting means (22, 28) comprises an AND gate (22); and
the combining means (23) comprises an OR gate.

4. The tree-like signal distribution network of any of the preceding claims, wherein the output of combining means is connected to two downstream branches of the tree-like distribution network.

5. A programmable logic device (21) comprising:
a tree-like distribution network (13) in accordance with any of claims 1 to 3;
an application data distribution network (14); and
a plurality of logic blocks (10), each logic block comprising at least one modified register, the modified register including:
a register (32) having an input connected to the application data distribution network and an input connected to the tree-like distribution network;
an output connected to the application data distribution network; and
switching means for switching either the input connected to the application data distribution network or the input connected to the tree-like distribution network to the output connected to the application data distribution network.

6. A programmable logic device in accordance with claim 4, wherein the register comprises a DQ-type flip-flop (32) and the switching means comprises a multiplexer (30).

7. A method of propagating a signal in the tree-like signal distribution network (13) of any of claims 1 to 4, the method comprising the steps of:
receiving a first signal from the tree-like signal distribution network;
receiving a second signal, the second signal being a locally generated signal;
selecting the first signal, the second signal or a combination of the first signal and the second signal as the propagation signal; and
propagating the propagation signal in the tree-like signal distribution network.

8. A method of modifying a signal using the tree-like signal distribution network (13) of any of claims 3 to 4, the method comprising the steps of:
receiving a first signal from the tree-like signal distribution network;
receiving a second signal from the tree-like signal distribution network; and
combining the first and second signals by inputting both signals into an OR gate.

9. A method of using the reconfigurable logic device (21) of any of claims 5 and 6, the method comprising the steps of:
receiving a first signal from the tree-like distribution network (13) at the modified register; and
setting the switching means (30) to output the first signal to the data distribution network.
